(19) Europäisches Patentamt
European Patent Office
Office européen des brevets

(11) **EP 3 051 651 B1**

## (12) EUROPÄISCHE PATENTSCHRIFT

(45) Veröffentlichungstag und Bekanntmachung des Hinweises auf die Patenterteilung:
**11.07.2018 Patentblatt 2018/28**

(21) Anmeldenummer: **16000152.5**

(22) Anmeldetag: **22.01.2016**

(51) Int Cl.:
*H02J 1/12* *(2006.01)*       *H02J 9/06* *(2006.01)*
*G01D 4/02* *(2006.01)*       *G01R 22/00* *(2006.01)*

(54) **SCHALTUNGSANORDNUNG ZUR ÜBERBRÜCKUNG VON SPANNUNGSUNTERBRECHUNGEN**

CIRCUIT ASSEMBLY FOR BRIDGING VOLTAGE INTERRUPTS

CIRCUIT DE PONTAGE D'INTERRUPTIONS DE TENSION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **29.01.2015 DE 202015000662 U**

(43) Veröffentlichungstag der Anmeldung:
**03.08.2016 Patentblatt 2016/31**

(73) Patentinhaber: **Elster GmbH**
**55252 Mainz-Kastel (DE)**

(72) Erfinder: **OHLEMÜLLER, Patrick**
**68167 Mannheim (DE)**

(74) Vertreter: **Eickmeyer, Dietmar**
**Patentanwaltskanzlei Bickert**
**Moltkestrasse 37**
**67122 Altrip (DE)**

(56) Entgegenhaltungen:
**US-A1- 2010 090 663    US-A1- 2014 266 073**

**Beschreibung**

Die Erfindung betrifft eine Schaltungsanordnung für eine Überbrückung von Spannungsunterbrechungen von an ein elektrisches Versorgungsnetz angeschlossenen elektronischen Geräten gemäß Anspruch 1 sowie eine Verwendung der Schaltungsanordnung in einer Einheit zur Erfassung von physikalischen Größen, insbesondere in einem elektronischen Verbrauchzähler, beispielsweise in einem elektronischen Wärmemengenzähler, Wasserzähler, Energieverbrauchszähler, elektronischen Stromzähler oder Gaszähler zur Erfassung von Energie- oder Fluidmengen und/oder deren auch nachrüstbaren Kommunikationsmodulen.

Auch bei einem Ausfall der Versorgungsspannung muss die elektrische Energieversorgung von elektronischen Geräten und deren temporären Versorgung mit elektrischer Energie gewährleistet sein.

Da viele elektronische Geräte mit einer elektrischen Spannung arbeiten, die nicht der Spannungsebene des allgegenwärtigen in europäischen Haushalten vorliegenden Niederspannungsnetzes von 230V bzw. 398Vrms entsprechen, werden zur Erzeugung bzw. Transformation der erforderlichen Kleinspannungen üblicherweise Netzteile verwendet.

Zwischen den einzelnen Leitern eines als Einphasen-Dreileiternetz ausgeführten Versorgungsnetzes, beispielsweise für Haushalte in Nordamerika, liegt typischerweise eine Spannung an, die sich nach folgender Formel bestimmt:

$$U = \sqrt{3} \bullet U_{\text{Versorgungsspannung}}$$

Für das, beispielsweise in Europa, verwendete Dreiphasennetz, liegt typischerweise eine Spannung an, die sich nach folgender Formel bestimmt:

$$U = \sqrt{3} \bullet 230V_{\text{rms}} \sim 398V_{\text{rms}}$$

Der Scheitelwert Vp dieser Spannung beträgt ca. 563Vrms und bestimmt sich folgendermaßen:

$$Vp = \sqrt{2} \bullet 398V_{\text{rms}} \sim 563V_{\text{peak}}$$

Bei zulässigen Spannungsschwankung von +/- 10 % ist somit eine Spannung zwischen den Leitern von ca. 437 Vrms bzw. ein Scheitelwert von ca. 620 Vpeak als Grundlage für weitere Betrachtungen zu berücksichtigen.

In europäischen Netzen können die elektrischen Geräte in den Haushalten der Spannung von 437 Vrms zwischen einem Leiter und Neutral-Potential bzw. Erde-Potential ausgesetzt sein, wenn ein Erdschlusses im Mittelspannungsnetz oder Hochspannungsnetz auftritt. Dieser Zustand muss jedoch nach der VDE-Norm 0105 innerhalb von vier Stunden aufgelöst werden.

Es ist möglich, dass elektronische Geräte zwischen zwei Leitern betrieben werden, beispielsweise elektronische Energieverbrauchszähler, und somit dauerhaft 398 Vrms Versorgungsspannung für ihre eigene energetische Versorgung umwandeln müssen.

Im Gegensatz zu früher genutzten 50/60 Hz Wechselspannungs-Transformatornetzteilen werden aktuell meistens Schaltnetzteile (Switch Mode Power Supply) eingesetzt.

Solche SMPS besitzen eine Vorstufe, die eine anliegende Wechselspannung (AC) in eine Gleichspannung (DC) umwandelt, um aus der erzeugten Gleichspannung in einer nachgeschalteten Wandlerstufe eine abweichende Spannungsebene oder eine galvanisch getrennten Spannung zu generieren.

Weiterhin existieren Schaltnetzteile, die ohne eine Umwandlung der anliegenden Wechselspannung in eine AC-Scheitelwert-Gleichspannung arbeiten, jedoch mit Energiespeichern ausgestattet sind, die sowohl vor als auch nach der Wandlerstufe angeordnet sind.

Die Umwandlung der Wechselspannung in eine Gleichspannung wird typischerweise mittels Gleichrichterschaltungen, die aus Einweg-Gleichrichtern oder Brückengleichrichtern aufgebaut sind, erreicht. Nachteilig ist hierbei, dass ab einer Leistungsaufnahme von ca. 500 Watt eine Leistungsfaktorkompensation notwendig ist, die sich mit der bekannten Diodentechnik nicht realisieren lässt.

Der gleichgerichteten Spannung sind üblicherweise Energiespeicher nachgeschaltet, die bevorzugt aus Elektrolytkondensatoren mit einer relativ hohen Kapazität aufgebaut sind und nur mit Gleichspannung betrieben werden dürfen. Handelsübliche Elektrolytkondensatoren weisen eine maximale elektrische Spannungsverträglichkeit von ca. 450V auf und sind somit theoretisch für gleichgerichtete Spannungen von maximal 320Vrms einsetzbar. Danach erfolgt ein elektrischer Durchbruch des isolierenden Elektrolyts und die Kondensatoren werden zerstört.

In der Praxis tritt dieser Effekt oft schon auf, wenn sich die elektrische Spannungsverträglichkeit der Kondensatoren dem zulässigen Maximalwert nähert. Zumindest verringert sich die Lebenserwartung der Elektrolytkondensatoren, wenn ca. 80% der in Datenblättern angegebenen maximalen elektrischen Spannungsverträglichkeit der Kondensatoren überschritten wird.

Werden die Schaltnetzteile mit Gleichrichterschaltungen also mit einer Versorgungspannung von> 276 Vrms betrieben (ergibt sich aus einer Spannungserhöhung um 20% bei einem bei 230 V Betrieb), ist es erforderlich ein Überschreiten der maximalen Spannung an den Kondensatoren zu verhindern.

Dies kann einerseits mittels einer Reihenschaltung von zwei Kondensatoren gleicher Kapazität realisiert werden. Mit dieser Schaltung verringert sich die Gesamtkapazität der Kondensatoren auf 50 % des nominalen Wertes eines einzelnen Kondensators, d.h. die effektiv nutzbare Energiemenge beider Kondensators halbiert sich. Zusätzlich benötigt eine solche Reihenschaltung der beiden Kondensatoren ein Kondensatormaterial - Volumen von 400 % gegenüber einem einzelnen Kondensator mit entsprechender Kapazität.

Andererseits kann einem einzelnen Kondensator ein Linearregler vorgeschaltet werden, wobei der Kondensator bis zu einem definierten Spannungslevel geladen werden kann und die gesamte Kapazität des Kondensators ist nutzbar. Während dem Nachladen des Kondensators fließt zusätzlich ein Strom durch den Linearregler, der eine nicht zu vernachlässigende Verlustleistung in Wärme umsetzt.

Der Erfindung liegt die Aufgabe zugrunde, eine Schaltungsanordnung für eine Überbrückung von Spannungsunterbrechungen von an ein elektrisches Versorgungsnetz angeschlossenen elektronischen Geräten anzugeben, wodurch vorgenannte Nachteile des Standes der Technik überwunden werden.

Diese Aufgabe wird erfindungsgemäß mit den in Anspruch 1 angegebenen Merkmalen gelöst. Vorteilhafte Ausgestaltungen, Verbesserungen der erfindungsgemäßen Schaltungsanordnung sowie eine Verwendung der Schaltungsanordnung in einem Verbrauchszähler, beispielsweise in einem elektronischen Wärmemengenzähler, Wasserzähler, elektronischen Stromzähler oder Gaszähler sind in weiteren Ansprüchen und in der Beschreibung angegeben.

Die erfindungsgemäße Schaltungsanordnung für eine Überbrückung von Spannungsunterbrechungen ist aus zwei in Reihe geschalteten Kondensatoren aufgebaut, die einen kapazitiven Spannungsteiler bilden, wobei einer der Kondensatoren, welcher als Speicherkondensator arbeitet, mit einem linearen Spannungsregler, auch Linearregler genannt, und einer Entlade-Diode bzw. Freilauf- Diode verschaltet ist. Der Speicherkondensator ist mit einer Kapazität ausgestattet, die es diesem ermöglicht, als SpeicherKondensator (Puffer-/ Buffer-Kondensator) zu arbeiten.

Der andere Kondensator ist dem Linearregler-Eingang und dem Linearregler- Ausgang parallel geschaltet, so dass dieser Kondensator ein Nachladen des Speicherkondensators durch den Linearregler verhindert. Somit wird im Linearregler die wärmeerzeugende Verlustleistung in vorteilhafter Weise reduziert.

Vorteilhafter Weise ist der Spannungsregler aus einem MOSFET- Transistor als Source-Folger aufgebaut. Die Ladespannung des Speicherkondensators ist durch den Spannungsabfall an der Referenzspannungs-Diode einstellbar.

Eine innerhalb des MOSFET- Transistors angeordnete Avalange-Diode arbeitet während einer Spannungsunterbrechung als Freilaufdiode.

Die Ladespannung des Speicherkondensators kann beispielsweise mittels einer Zener-Diode, Suppressor-Diode oder eines Varistor einstellbar sein.

Als Gate-Schutz-Diode des MOSFET- Transistors kann eine Zener- Diode oder eine Suppressordiode vorgesehen sein, welche die Spannung zwischen Gate und Source des MOSFET-Transistors begrenzt.

Die zwischen dem Vorwiderstand, der Zener- Diode oder der Suppressor- Diode zur Einstellung der Ladespannung des Speicherkondensators und dem Gate des MOSFET-Transistors zwischengeschaltete Entlade- Schutz-Diode kann durch eine Kurzschlussverbindung ersetzt sein, wobei in dieser vorteilhaften Ausführungsform der Widerstand zur Beschleunigung des Sperr-Verhaltens des MOSFET- Transistors entfällt.

In einer weiteren vorteilhaften Ausführungsform der erfindungsgemäßen Schaltungsanordnung sind die als Suppressordiode ausgeführte Gate-Schutz-Diode und die Suppressor- Diode zur Einstellung der Ladespannung des Speicherkondensators durch entsprechend dimentionierte Zener-Dioden ersetzt und der Gate-Schutz-Diode ist die Entlade-Schutz-Diode in Sperrrichtung nachgeschaltet.

Weiterhin ist die für den Speicherkondensator spannungsbestimmende Spannung durch eine Suppressor-Diode einstellbar.

Vorzugsweise ist die erfindungsgemäße Schaltungsanordnung im Versorgungsnetz eines Verbrauchszählers angeordnet.

Anhand von dem in den folgenden Figuren dargestellten Ausführungsbeispielen sollen die Erfindung sowie vorteilhafte Ausgestaltungen, Verbesserungen und weitere Vorteile der Erfindung näher erläutert und beschrieben werden.

Es zeigen:

Fig. 1 ein beispielhaftes Blockschaltbild der erfindungsgemäßen Schaltungsanordnung,
Fig. 2 eine erste beispielhafte Ausführungsvariante der erfindungsgemäßen Schaltungsanordnung,
**Fig. 3** eine zweite beispielhafte Ausführungsvariante der erfindungsgemäßen Schaltungsanordnung,
**Fig. 4** eine dritte beispielhafte Ausführungsvariante der erfindungsgemäßen Schaltungsanordnung,
Fig. 5 eine vierte beispielhafte Ausführungsvariante der erfindungsgemäßen Schaltungsanordnung,
Fig. 6 eine fünfte beispielhafte Ausführungsvariante der erfindungsgemäßen Schaltungsanordnung, und
Fig. 7 eine weitere beispielhafte Ausführungsvariante der erfindungsgemäßen Schaltungsanordnung.

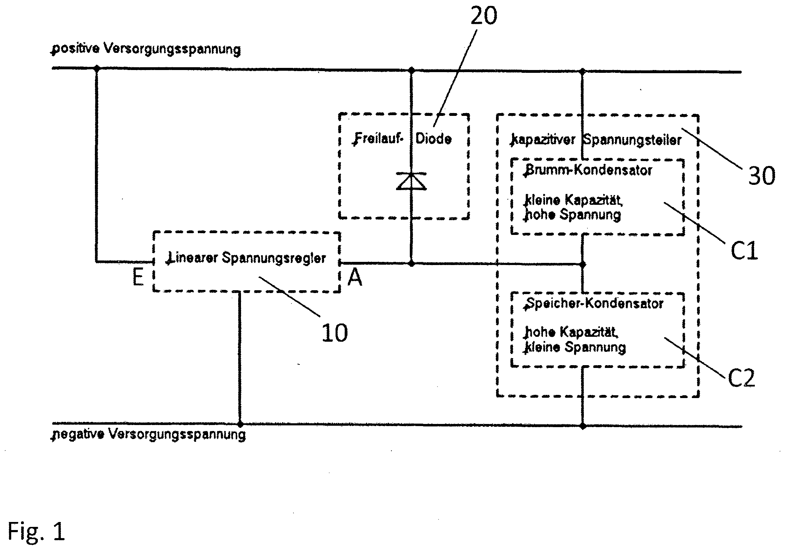

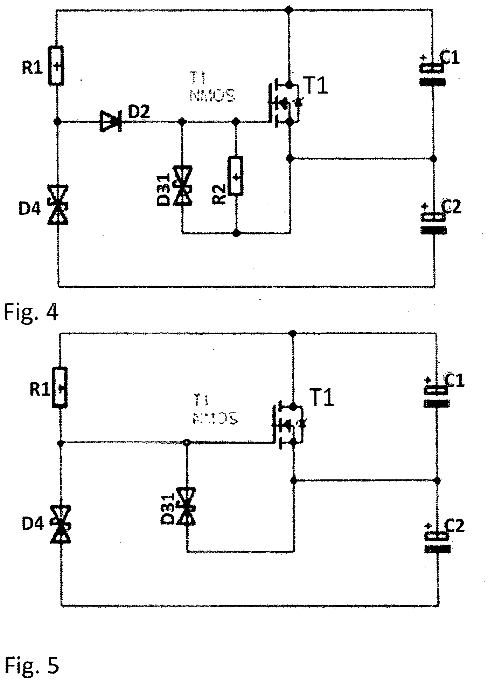

Fig. 1 zeigt ein beispielhaftes Blockschaltbild der erfindungsgemäßen Schaltungsanordnung für eine Überbrückung von Spannungsunterbrechungen eines an ein elektrisches Versorgungsnetz angeschlossenen elektronischen Gerätes.
Die erfindungsgemäße Schaltungsanordnung ist an die Versorgungsspannung eines an ein elektrisches Versorgungsnetz angeschlossenen elektronischen Gerätes, vorzugsweise eines Verbrauchszählers, angeschlossen und umfasst zwei in Reihe geschalteten Kondensatoren C1, C2, die einen kapazitiven Spannungsteiler 30 bilden, wobei einer der Kondensatoren C2, welcher als Speicherkondensator arbeitet, mit einem linearen Spannungsregler 10 und einer Entlade-Diode 20 verschaltet ist und der andere Kondensator C1, auch Brumm-Kondensator genannt, dem Linearregler-Eingang E und dem Linearregler- Ausgang A des Spannungsreglers 10 parallel geschaltet ist, so dass dieser Kondensator C1 das 50/ 60 HZ pulsierende Nachladen des Speicherkondensators C2 durch den Linearregler 10 verhindert.
Der Kondensator C1 weist eine niedrige Kapazität (z.B. 6,8 $\mu$F) auf. Der Speicherkondensator C2 ist als hochkapazitiver Speicherkondensator (z.B. 68 $\mu$F) ausgeführt, dessen elektrische Speicherfähigkeit gegenüber herkömmlichen Kondensatoren ist deutlich höher ist. Am Speicherkondensator liegt eine geringere Spannung als am Kondensator C1 an.

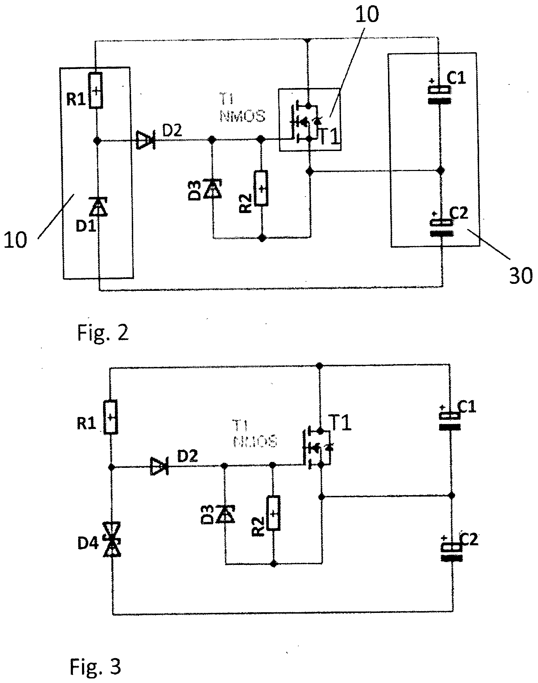

Fig. 2 zeigt eine erste beispielhafte Ausführungsvariante der erfindungsgemäßen Schaltungsanordnung, welche die Kondensatoren C1 und C2 umfasst, die den kapazitiven Spannungsteiler 30 bilden. Der Linearregler 10 ist aus einem MOSFET- Transistor T1, einer Zener-Diode D1 und einem Vorwiderstand R1 aufgebaut. Die Ladespannung des Speicherkondensators C2 wird durch den Spannungsabfall an der Zener- Diode D1 eingestellt. Die innerhalb des MOSFET- Transistors T1 angeordnete Avalange-Diode arbeitet als Freilaufdiode während einer Spannungsunterbrechung. Um den MOSFET-Transistor T1 vor auftretenden Überspannungen zu schützen ist dem Gate des MOSFET- Transistor T1 eine weitere Zener- Diode D3 als Gate-Schutz-Diode in Sperrrichtung vorgeschaltet. Der weiteren Zener- Diode D3 ist ein Widerstand R2 parallelgeschaltet. Der Widerstand R2 beschleunigt das Sperr-Verhalten des MOSFET- Transistors T1.
Eine zwischen dem Vorwiderstand R1, der Zener- Diode D1 und dem Gate des MOSFET- Transistors T1 zwischengeschaltete Diode D2 verhindert ein Entladen des Speicherkondensators C2 über die Zener-Dioden D1, D3.
In der in der **Fig. 3** gezeigten beispielhaften Ausführungsvariante der erfindungsgemäßen Schaltungsanordnung ist die Zener-Diode D1, welche die Ladespannung des Speicherkondensators C2 eingestellt, durch eine Suppressor- Diode D4, auch als Transient Absorption Zener- Diode (TAZ-Diode) oder Transient Voltage Suppressor Diode (TVS-Diode) genannt Diode bekannt, ersetzt.
In der in der **Fig. 4** gezeigten beispielhaften Ausführungsvariante der erfindungsgemäßen Schaltungsanordnung ist die als Zener- Diode ausgeführte Gate-Schutz-Diode D3 des MOSFET- Transistors T1 durch eine weitere Suppressordiode D31 ersetzt. Die Ladespannung des Speicherkondensators C2 wird wie in Fig. 3 beschrieben mittels der Suppressordiode D4 eingestellt.
Bei der in der in der **Fig. 5** gezeigten beispielhaften Ausführungsvariante der erfindungsgemäßen Schaltungsanordnung ist die zwischen dem Vorwiderstand R1, der Zener- Diode D1 oder der Suppressor- Diode D4 und dem Gate des MOSFET- Transistors T1 zwischengeschaltete Entlade- Schutz-Diode D2 durch eine Kurzschlussverbindung ersetzt. Der in den Fig. 1 - 4 vorgesehene Widerstand R2 zur Beschleunigung des Sperr-Verhaltens des MOSFET- Transistors T1 entfällt.

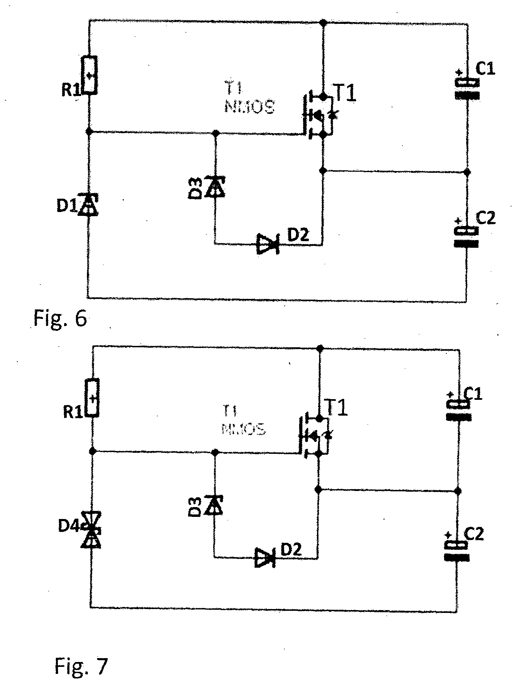

Fig. 6 zeigt eine Ausführungsvariante der erfindungsgemäßen Schaltungsanordnung, wobei die beiden in der Fig. 5 gezeigten Suppressordioden D4, D31 durch Zener-Dioden D1, D3 ersetzt sind. Die Entlade-Schutz-Diode D2 ist der Gate-Schutz-Diode D3 in Sperrrichtung nachgeschaltet.
In der **Fig. 7** ist eine weitere beispielhafte Ausführungsvariante der erfindungsgemäßen Schaltungsanordnung, wobei die in der Fig. 6 dargestellt Schaltung dahingehend abgewandelt wurde, dass die für den Speicherkondensator C2 spannungsbestimmende Spannung durch eine Suppressor-Diode D4 eingestellt wird.

Die erfindungsgemäße Schaltung ist nicht auf die in den Figuren 2 bis 7 beschriebenen Ausführungsbeispiele beschränkt. Es ist auch weitere Kombinationen der dort gezeigten Schaltungen möglich sind.

Bezuqszeichenliste

| | |
|---|---|
| 10 | linearer Spannungsregler, Linearregler |
| 20 | Entlade-Diode |
| 30 | kapazitiver Spannungsteiler |
| C1 | Kondensator |
| C2 | Speicherkondensator |
| E | Linearregler-Eingang |
| A | Linearregler-Ausgang |
| R1 | Vorwiderstand |
| R2 | Widerstand zur Beschleunigung des Sperr-Verhaltens des MOSFET- Transistors |
| D1 | Zener-Diode, Referenzspannungsdiode |
| D2 | Entlade- Schutz-Diode zur Verhinderung der Entladung des Speicherkondensators |
| D3 | Gate-Schutz-Diode, Zener- Diode |
| D31 | Gate-Schutz-Diode Suppressordiode |
| D4 | Suppressor- Diode, TAZ-Diode, TVS-Diode zur Einstellung der Ladespannung des Speicherkondensators |
| T1 | MOSFET- Transistor |

**Patentansprüche**

1. Schaltungsanordnung für eine Überbrückung von Spannungsunterbrechungen mit zwei in Reihe geschalteten Kondensatoren (C1, C2), die einen kapazitiven Spannungsteiler (30) bilden, wobei einer der Kondensatoren (C2), welcher als Speicherkondensator arbeitet, mit einem linearen Spannungsregler (10) und einer Entlade-Diode (20) verschaltet ist und der andere Kondensator (C1) dem Linearregler-Eingang (E) und dem Linearregler- Ausgang (A) des Spannungsreglers (10) parallel geschaltet ist, so dass der andere Kondensator (C1) ein Nachladen des Speicherkondensators (C2) durch den Linearregler (10) verhindert.

2. Schaltungsanordnung nach Anspruch 1, **dadurch gekennzeichnet, dass** der Spannungsregler (10) aus einem MOSFET- Transistor (T1), einer Gate-Schutz-Diode und einem Vorwiderstand (R1) aufgebaut ist und die Ladespannung des Speicherkondensators (C2) durch den Spannungsabfall an der Gate-Schutz-Diode einstellbar ist.

3. Schaltungsanordnung nach Anspruch 2, **dadurch gekennzeichnet, dass** eine innerhalb des MOSFET- Transistors (T1) angeordnete Avalange-Diode als Freilaufdiode während einer Spannungsunterbrechung wirkt.

4. Schaltungsanordnung nach einem der vorstehenden Ansprüche, **dadurch gekennzeichnet, dass** die Ladespannung des Speicherkondensators (C2) durch eine Zener-Diode (D1) oder eine Suppressor- Diode (D4) einstellbar ist.

5. Schaltungsanordnung nach einem der Ansprüche 2 bis 4, **dadurch gekennzeichnet, dass** als Gate-Schutz-Diode des MOSFET- Transistors (T1) eine Zener- Diode (D3) oder eine Suppressordiode (D31) vorgesehen ist, um die Ladespannung des Speicherkondensators (C2) einzustellen.

6. Schaltungsanordnung nach einem der Ansprüche 2 bis 5, **dadurch gekennzeichnet, dass** die zwischen dem Vorwiderstand (R1), der Zener-Diode (D1) oder der Suppressor- Diode (D4) und dem Gate des MOSFET- Transistors (T1) zwischengeschaltete Entlade- Schutz-Diode (D2) durch eine Kurzschlussverbindung ersetzt ist und der Widerstand (R2) zur Beschleunigung des Sperr-Verhaltens des MOSFET- Transistors (T1) entfällt.

7. Schaltungsanordnung nach einem der Ansprüche 5 oder 6, **dadurch gekennzeichnet, dass** die Suppressordioden (D4), (D31) durch Zener-Dioden (D1), (D3) ersetzt sind und die Entlade-Schutz-Diode (D2) der Gate-Schutz-Diode (D3) in Sperrrichtung nachgeschaltet ist.

8. Schaltungsanordnung nach einem der Ansprüche 2 bis 7, **dadurch gekennzeichnet, dass** die für den Speicherkondensator (C2) spannungsbestimmende Spannung durch eine Suppressor-Diode (D4) einstellbar ist.

9. Verwendung der Schaltungsanordnung nach einem der Ansprüche 1 bis 8 in einer Einheit zur Erfassung von physikalischen Größen, insbesondere in einem Verbrauchszähler, insbesondere in elektronischen Wärmemengenzählern, Wasserzählern, Stromzähler oder Gaszähler zur Erfassung von Energie- oder Fluidmengen und/oder deren auch nachrüstbaren Kommunikationsmodulen..

## Claims

1. Circuit arrangement for bridging voltage interruptions comprising-two capacitors (C1, C2), which are connected in series and form a capacitive voltage divider (30), wherein one of the capacitors (C2), which operates as a storage capacitor, is interconnected with a linear voltage regulator (10) and a discharge diode (20) and the other capacitor (C1) is connected in parallel with the linear regulator input (E) and the linear regulator output (A) of the voltage regulator (10) so that the other capacitor (C1) prevents recharging of the storage capacitor (C2) by the linear regulator (10).

2. Circuit arrangement according to Claim 1, **characterized in that** the voltage regulator (10) is constructed from a MOSFET transistor (T1), a gate protection diode and a series resistor (R1) and the charging voltage of the storage capacitor (C2) can be set by the voltage drop across the gate protection diode.

3. Circuit arrangement according to Claim 2, **characterized in that** an avalanche diode arranged within the MOSFET transistor (T1) acts as a freewheeling diode during a voltage interruption.

4. Circuit arrangement according to one of the preceding claims, **characterized in that** the charging voltage of the storage capacitor (C2) can be set by a Zener diode (D1) or a suppressor diode (D4).

5. Circuit arrangement according to one of Claims 2 to 4, **characterized in that** a Zener diode (D3) or a suppressor diode (D31) is provided as gate protection diode of the MOSFET transistor (T1) in order to set the charging voltage of the storage capacitor (C2).

6. Circuit arrangement according to one of Claims 2 to 5, **characterized in that** the discharge protection diode (D2) interconnected between the series resistor (R1), the Zener diode (D1) or the suppressor diode (D4) and the gate of the MOSFET transistor (T1) is replaced by a short-circuit connection and the resistor (R2) is omitted for the purpose of accelerating the blocking response of the MOSFET transistor (T1).

7. Circuit arrangement according to either of Claims 5 and 6, **characterized in that** the suppressor diodes (D4), (D31) are replaced by Zener diodes (D1), (D3) and the discharge protection diode (D2) is connected downstream of the gate protection diode (D3) in the blocking direction.

8. Circuit arrangement according to one of Claims 2 to 7, **characterized in that** the voltage that determines the voltage for the storage capacitor (C2) can be set by a suppressor diode (D4).

9. Use of the circuit arrangement according to one of Claims 1 to 8 in a unit for detecting physical variables, in particular in a consumption meter, in particular in electronic heat meters, water meters, electricity meters or gas meters for the purpose of detecting amounts of energy or fluid and/or the communication modules thereof that can also be retrofitted.

## Revendications

1. Arrangement de circuit pour un pontage d'interruptions de tension, comprenant deux condensateurs (C1, C2) branchés en série, lesquels forment un diviseur de tension (30) capacitif, l'un des condensateurs (C2), qui fait office de condensateur d'accumulation, étant connecté à un régulateur de tension linéaire (10) et une diode de décharge (20) et l'autre condensateur (C1) étant branché en parallèle avec l'entrée de régulateur linéaire (E) et la sortie de régulateur linéaire (A) du régulateur de tension (10), de sorte que l'autre condensateur (C1) empêche une recharge du condensateur d'accumulation (C2) à travers le régulateur linéaire (10).

**2.** Arrangement de circuit selon la revendication 1, **caractérisé en ce que** le régulateur de tension (10) est constitué d'un transistor MOSFET (T1), d'une diode de protection de la gâchette et d'une résistance protectrice (R1) et la tension de charge du condensateur d'accumulation (C2) est réglable par la chute de tension aux bornes de la diode de protection de la gâchette.

**3.** Arrangement de circuit selon la revendication 2, **caractérisé en ce qu'**une diode avalanche disposée à l'intérieur du transistor MOSFET (T1) sert de diode de roue libre pendant une interruption de tension.

**4.** Arrangement de circuit selon l'une des revendications précédentes, **caractérisé en ce que** la tension de charge du condensateur d'accumulation (C2) est réglable par une diode zener (D1) ou une diode transil (D4).

**5.** Arrangement de circuit selon l'une des revendications 2 à 4, **caractérisé en ce que** la diode de protection de la gâchette du transistor MOSFET (T1) prévue est une diode zener (D3) ou une diode transil (D31) servant à régler la tension de charge du condensateur d'accumulation (C2).

**6.** Arrangement de circuit selon l'une des revendications 2 à 5, **caractérisé en ce que** la diode de protection de décharge (D2) qui est interconnectée entre la résistance protectrice (R1), la diode zener (D1) ou la diode transil (D4) et la gâchette du transistor MOSFET (T1) est remplacée par une liaison de court-circuit et la résistance (R2) servant à accélérer le comportement de blocage du transistor MOSFET (T1) est supprimée.

**7.** Arrangement de circuit selon l'une des revendications 5 ou 6, **caractérisé en ce que** les diodes transil (D4), (D31) sont remplacées par des diodes zener (D1), (D3) et la diode de protection de décharge (D2) est branchée en aval de la diode de protection de gâchette (D3) dans le sens du blocage.

**8.** Arrangement de circuit selon l'une des revendications 2 à 7, **caractérisé en ce que** la tension qui détermine la tension pour le condensateur d'accumulation (C2) est réglable par une diode transil (D4) .

**9.** Utilisation de l'arrangement de circuit selon l'une des revendications 1 à 8 dans une unité servant à collecter des grandeurs physiques, notamment dans un compteur de consommation, notamment dans des compteurs de chaleur électroniques, des compteurs d'eau, des compteurs électriques ou des compteurs de gaz servant à collecter des quantités d'énergie ou de fluide et/ou leurs modules de communication pouvant également être installés à postériori.

EP 3 051 651 B1

positive Versorgungsspannung

20

Freilauf- Diode

kapazitiver Spannungsteiler

30

Brumm-Kondensator

kleine Kapazität, hohe Spannung

C1

Linearer Spannungsregler

E

A

10

Speicher-Kondensator

hohe Kapazität, kleine Spannung

C2

negative Versorgungsspannung

Fig. 1

Fig. 2

Fig. 3

EP 3 051 651 B1

Fig. 4

Fig. 5

Fig. 6

Fig. 7